# EUROPEAN PATENT SPECIFICATION

(11) **EP 2 963 426 B1**
(45) Date of publication and mention of the grant of the patent: **30.05.2018**
(21) Application number: 14002226.0
(22) Date of filing: 30.06.2014
(51) Int. Cl.: G01R 1/20, G01R 19/00, B60L 3/12

(54) **Measuring arrangement for measuring direct and alternating current**
Messanordnung zum Messen von Gleich- und Wechselstrom
Dispositif de mesure pour mesurer un courant continu et alternatif

(43) Date of publication of application: 06.01.2016
(73) Proprietor: Microelettrica Scientifica S.p.A., 20090 Buccinasco (Milano) (IT)
(72) Inventor: Battistella, Denis, I-20037 Paderno Dugnano (MI) (IT)
(74) Representative: von Bülow & Tamada

(56) References cited:
- EP-A1- 2 312 327
- EP-A2- 1 844 970
- EP-A2- 1 947 465
- DE-A1-102009 045 310
- DE-A1-102009 057 282
- DE-B- 1 163 965
- FR-A1- 2 897 689
- US-A1- 2011 221 424

## Description

The invention relates to a measuring arrangement for measuring electric DC and AC currents, and in particular for the measurement of electrical AC and DC currents for the operation of electrically driven vehicles, in which for measuring the electric current, a voltage drop across a shunt-resistance is measured, wheretrough the current to be measured flows. The invention relates further to the use of such a measuring device an electrically driven vehicle, which is adapted for operation with alternating voltage and with direct voltage.
Electrically powered vehicles are often operated with different supply voltages from a power supply line, such as a catenary line or a conductor rail. Common are:
- AC voltage of 25 kV at 50 Hz,
- AC voltage of 15 kV 60.7 Hz,
- DC 3 kV,
- DC voltage of 1.5 kV and
- DC voltage of 750 V.
(Cf, the standard EN 50163)

During operation of the vehicle, the absorbed electrical current has to be measured, which is accomplished by the above-mentioned electrical measurement setup.

In the above-mentioned applications with said normal operating voltages of railway vehicles the maximum current in the AC voltages is typically 400 A (peak to peak) whereas at the DC voltages the maximum current is, however, up to 4000 A. In other words, the dynamic range for the two cases is highly different.

Using a single shunt resistor, the maximum voltage drop at a direct current of 4000 A, for example, would be 20 mV, whereas with a maximum alternating current of 400 A, however, only 1/10 of this value, namely 2 mV voltage drop would occur. Additional, measurement errors could be caused by an offset and by gain errors in the latter case, so that for the two cases described, the desired accuracy can not be achieved.

Document DE 10 2009 045 310 A1 discloses a measurement arrangement according to the preamble part of claim 1.

Document US 2011/0221424 A1 discloses a current sense circuit, including a voltage regulator, for detecting current conducted by a device under test for a wide range of currents, while still providing fine granularity for detecting low/small currents.

Document FR 2 897 689 A1 discloses a device having a conductor that is connected to an electric circuit in which a current to be measured circulates, and with conducting branches respectively for passage of strong and weak current.

Document EP 1 844 970 A2 discloses a system having electrically operated local traffic vehicles e.g. street cars, each with a board-fixed measuring device for on-line measurement of the electrical energy consumed by the local traffic vehicle and for storage of corresponding energy consumption data.

Document DE 10 2009 057 282 A1 discloses a system having a load sided alternating current motor with a resistor for determining direct voltage intermediate circuit current and phase current of a bridge section of an inverter module.

The object of the invention is therefore to improve the measurement arrangement of the kind mentioned in that it allows for improved accuracy for the measurement of DC and AC current measurement on rail vehicles.

This object is solved by the features of claim 1. Advantageous embodiments and further developments of the invention are disclosed in the dependent claims.

The basic idea of the invention is to use different shunt resistors for the measurement of direct current and for the measurement of alternating current.

Preferably, the ohmic values of the shunt resistors are selected such that the voltage drop across each shunt resistor at the maximum occurring direct current and at the maximum occurring alternating current is equal.

With the voltage and current values mentioned above, the ohmic resistance value of the shunt resistor used for measuring the direct current is preferably ten times the ohmic resistance value of the shunt resistor used for measuring the alternating current.

Preferably, the two shunt resistors are dimensioned so that at the maximum possible direct current and at the maximum possible AC an similar, preferably equal, voltage drop occurs at the associated shunt resistor.

In the following the invention will be explained in detail with reference to an embodiment in conjunction with the drawings. In which:
Figure 1 is a perspective view of a measurement arrangement according to the invention;

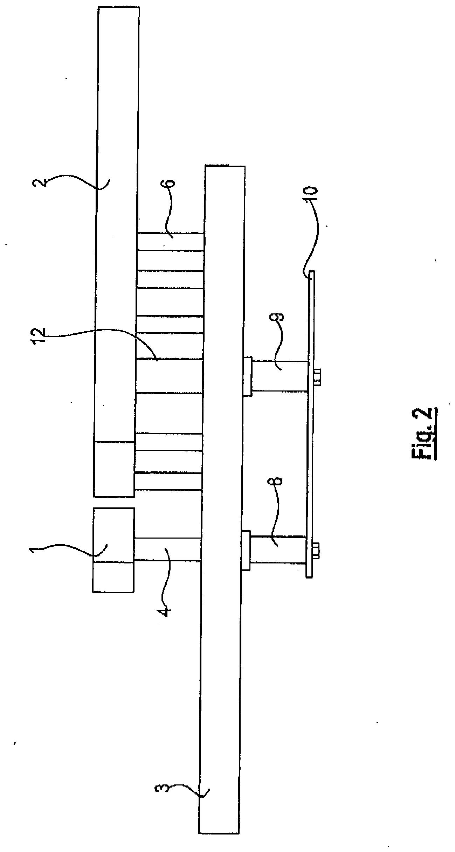

Figure 2 is a side view of the measurement arrangement of Figure 1;
Figure 3 is a sectional view of an voltage picking point of the measurement arrangement of Figure 1 and 2.

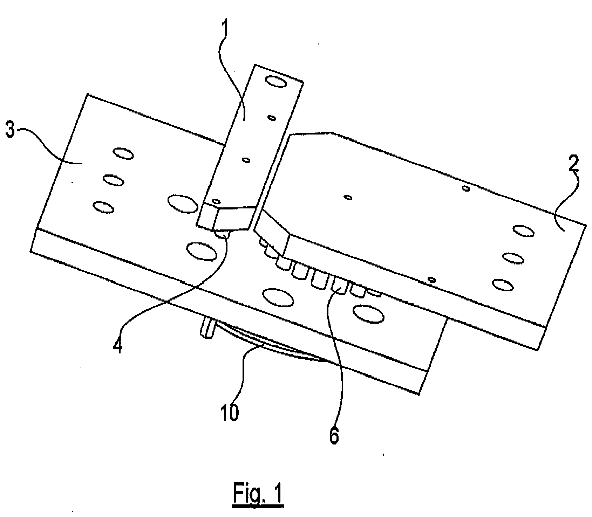

Figure 1 is shows an input line 1, on which an AC voltage is applied, which is taken for example from a current collector of a vehicle from an overhead line, a second input line 2 for DC current, and an output line 3, connected to the vehicle main supply line circuit.

The input line 1 and the input line 2 are made in the form of a flat plate of electrically conductive material. Both are located in a first plane. The output line 3 shows also the form of a flat plate located in a second plane, which is offset to the first plane.

Between the input line 1 and the output line 3 at least one first shunt resistor 4 is arranged which electrically connects the input line 1 with the output line 3. Similarily, at least one second shunt resistor 6 is disposed between the second input line 2 and the output line 3, connecting the input line 2 with the output line 3. These shunt resistors 4 and 6 establish also a mechanical connection between the input lines 1 and 2 and the output line 3.

The two shunt resistors 4 and 6 have different ohmic resistance values, which are adapted to the maximum current occurring in each case.

The two input lines 1 and 2 are each connected via a signal line 8 and 9 with a printed circuit board 10 on which takes place the actual measurement of the voltage drop across each shunt resistor 4, 6. A measurement signal generated here is output through an additional output line, not shown.

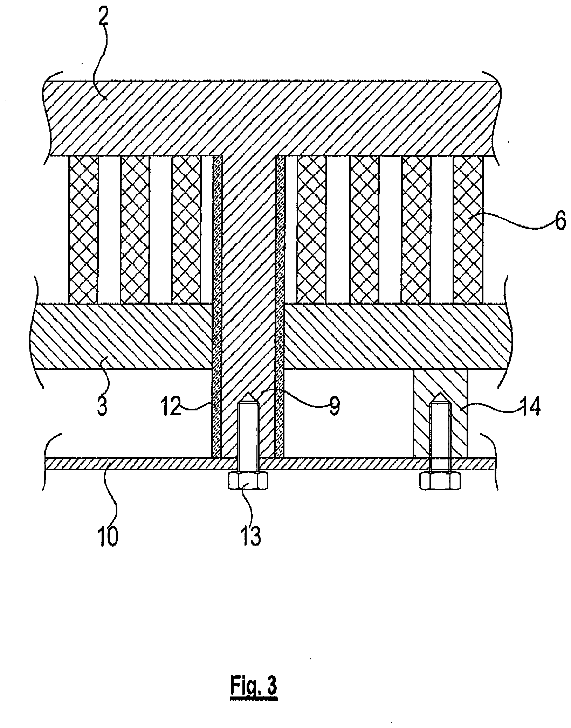

Figure 3 shows a sectional view of such a signal line 9. This signal line 9 is here electrically and mechanically connected with the input line 2 and is surrounded by an electrically insulating sleeve 12 running through a boring of the output line 3 upwards to the wiring board 10. This signal line 9 is attached to the board 10 by a screw 13 and electrically connected with measuring elements on the wiring board 10.
The output line 3 is also electrically connected with the wiring board 10 by an electric line 14. Therewith the voltage drop on the shunt resistors 6 occurs at the signal line 9 and the line 14 and can be measured.
The same voltage picking arrangement is also provided between the input line 1 and the output line 3.
In the herein described and provided for in the present invention application in electric vehicles, which can be supplied with different voltages, the maximum alternating currents are substantially less than the maximum possible DC currents. For this reason, the cross-section of the input line 1 is also substantially smaller than the cross section of the inlet line 2. The cross section of the output line 3, however, is dimensioned so that it can conduct the maximum DC current.

## Claims

1. Measurement arrangement for measuring of electrical AC and DC current, in which to measure the electric current, a voltage drop of the current traversing a shunt resistor (4,6) is measured, wherein two separate shunt resistors (4, 6) are provided, namely a first shunt resistor (4) for measuring of the alternating current, and a second shunt resistor (6) for measuring the DC current, wherein the ohmic resistance values of the shunt resistors (4,6) are different, and wherein the separate shunt resistors (4, 6) are electrically and mechanically connecting a first input line (1) for AC current and a second input line (2) for DC current, respectively, with an output line (3), wherein the two input lines (1, 2) are located in a first plane and the output line (3) is located in a second plane wherein the shunt resistors (4, 6) are bridging these planes, **characterized in that** each input line (1, 2) is connected with a signal line (8, 9) surrounded by an electrically insulating sleeve (12) extending through a boring of the output line (3) and being electrically and mechanically connected with a wiring board (10), whereon a measuring device is located.

2. Measuring arrangement according to claim 1, **characterized in that** said first shunt resistor (4) has an ohmic resistance which is larger, preferably by a factor of 10, than the ohmic resistance provided for the measurement of the direct current second shunt resistor (6).

3. Using a measuring arrangement according to claim 1 or 2 in an electrically driven vehicle, which is adapted for operation with alternating voltage and with direct voltage.

## Patentansprüche

1. Messanordnung zum Messen eines elektrischen AC und DC Stromes, in der zum Messen des elektrischen Stromes ein Spannungsabfall des Stromes, der einen Shuntwiderstand (4, 6) durchläuft, gemessen wird, wobei zwei verschiedene Shuntwiderstände (4, 6) bereitgestellt werden, nämlich ein erster Shuntwiderstand (4) zum Messen des Wechselstromes und ein zweiter Shuntwiderstand (6) zum Messen des DC Stromes, wobei die ohmschen Widerstandswerte der Shuntwiderstände (4, 6) verschieden sind und wobei die verschiedenen Shuntwiderstände (4, 6) elektrisch und mechanisch eine erste Eingangsleitung (1) für AC Strom und eine zweite Eingangsleitung (2) für DC Strom entsprechend mit einer Ausgangsleitung (3) verbinden, wobei die zwei Eingangsleitungen (1, 2) in einer ersten Ebene angeordnet sind und die Ausgangsleitung (3) in einer zweiten Ebene angeordnet ist, wobei die Shuntwiderstände (4, 6) diese Ebenen überbrücken, **dadurch gekennzeichnet, dass** jede Eingangsleitung (1, 2) mit einer Signalleitung (8, 9) verbunden ist, die von einer elektrisch isolierenden Hülse (12) umgeben ist, die sich durch eine Bohrung der Ausgangsleitung (3) erstreckt und die elektrisch und mechanisch mit einer Leiterplatte (10) verbunden ist, auf sich ein Messgerät befindet.

2. Messanordnung nach Anspruch 1, **dadurch gekennzeichnet**, das der erste Shuntwiderstand (4) einen ohmschen Widerstand besitzt, der größer ist, vorzugsweise mit dem Faktor 10, als der ohmsche Widerstand, der für die Messung des Gleichstromshuntwiderstandes (6) bereitgestellt ist.

3. Verwendung einer Messanordnung nach Anspruch 1 oder 2 in einem elektrisch getriebenen Fahrzeug, das für einen Betrieb mit Wechselspannung und mit Gleichspannung eingerichtet ist.

## Revendications

1. Dispositif de mesure pour mesurer un courant électrique alternatif et continu, dans lequel pour mesurer le courant électrique, on mesure une chute de tension du courant traversant une résistance shunt (4, 6), dans lequel on prévoit deux résistances shunt (4, 6), à savoir une première résistance shunt (4) pour mesurer le courant alternatif, et une seconde résistance shunt (6) pour mesurer le courant continu, dans lequel les valeurs de résistance ohmique des résistances shunt (4, 6) sont différentes, et dans lequel les résistances shunt (4, 6) connectent électriquement et mécaniquement un premier conducteur d'entrée (1) pour le courant alternatif et un second conducteur d'entrée (2) pour le courant continu, respectivement, avec un conducteur de sortie (3), dans lequel les deux conducteurs d'entrée (1, 2) sont disposés dans un premier plan et le conducteur de sortie (3) est disposé dans un second plan et les résistances shunt (4, 6) font un pont entre ces plans, **caractérisé en ce que** chaque conducteur d'entrée (1, 2) est connecté à une ligne de signal (8, 9) qui est entourée par une enveloppe électriquement isolante (12) s'étendant à travers un trou du conducteur de sortie (3) et qui est connectée électriquement et mécaniquement à une carte de câblage, sur laquelle est placé un dispositif de mesure.

2. Dispositif de mesure selon la revendication 1, **caractérisé en ce que** ladite première résistance shunt (4) a une valeur de résistance ohmique qui est plus grande, de préférence selon un facteur de 10, que la valeur de résistance ohmique de la seconde résistance shunt (6) prévue pour la mesure du courant continu.

3. Utilisation d'un dispositif de mesure selon la revendication 1 ou 2 dans un véhicule à traction électrique, qui est adapté pour le fonctionnement avec une tension alternative et avec une tension continue.
